# EUROPEAN PATENT APPLICATION

(11) **EP 1 732 106 A1**
(43) Date of publication of application: **13.12.2006**
(21) Application number: 06076130.1
(22) Date of filing: 31.05.2006
(51) Int. Cl.: H01L 21/00

(54) **A component supplying device and method**

(30) Priority: 07.06.2005 NL 1029206
(71) Applicant: Assembléon N.V., 5503 LA Veldhoven (NL)
(72) Inventor: Hoogers, Hubert Francijn Maria, 5513 BR Wintelre (NL); Slegers, Roland Leo Bas, 5261 AK Vught (NL)
(74) Representative: Veldman-Dijkers, Cornelia G. C.

(57) **Abstract**

A component supplying device (1) is provided with at least a wafer holder (2) and at least a first (6) and a second (7) component pick-up device, which are movable along a first (4) and a second (5) guide, respectively, which guides are arranged at an angle relative to one another. The first component pick-up device (6) is movable between a pick-up position (10) located near the wafer holder (2) and a first supply position (11), while the second component pick-up device (7) is movable between the pick-up position (10) and a second supply position (12).

## Description

The invention relates to a component supplying device that is provided with at least a wafer holder and at least a component pick-up device that is movable along a guide, which device is movable between at least a pick-up position located near the wafer holder and a supply position spaced therefrom by some distance.

The invention also relates to a component supplying device according to any one of the preceding claims.

In such a component supplying device as known from US patent 5,671,530 the wafer holder supports a wafer provided with components. The wafer is affixed to a film, which film is stretched in the wafer holder, as a result of which the components of the wafer will be spaced some distance apart, so that they can be picked up from the film more easily. A component is picked up from a pick-up position of the wafer by means of the component pick-up device that can be moved to and fro along the guide, after which said component is moved to a supply position by means of the component pick-up device. From the supply position the component is placed at a desired position on a substrate by means of a component pick-up and placement device that is known per se.

A disadvantage of the known component supplying device known per se is that the wafer-supported components can be supplied only at a single one supply position.

The object of the invention is to provide a component supplying device by means of which components can be supplied at several supply positions.

This object is achieved with the component supplying device according to the invention in that the component supplying device is provided with at least a first and a second component pick-up device, which are movable along a first and a second guide, respectively, which guides are arranged at an angle relative to one another, the first component pick-up device being movable between the pick-up position and a first supply position, while the second component pick-up device is movable between the pick-up position and a second supply position.

The guides arranged at an angle relative to one another make it possible to pick up components from the same pick-up position alternately with the first and the second component pick-up device, after which they can be supplied at different supply positions. As a result, the frequency at which the components diriving from the wafer are supplied is relatively high. Furthermore it is also possible in this manner to provide more than one supply position in the space taken up by the wafer holder, which ensures that optimum use is made of the available space. The angle is more than 0°. Because of the guides arranged at an angle relative to one another, the component pick-up devices may be designed to be substantially identical or mirrored.

An embodiment of the component supplying device according to the invention is characterized in that the wafer holder extends substantially horizontally.

Because the wafer holder and hence the wafer supported by the wafer holder extend horizontally, the components supported by the wafer will be held on the wafer holder by the force of gravity, and will not be able to undesirably drop from the wafer. In this embodiment the guides may also extend horizontally above the wafer holder, while the supply positions may lie next to one another along a horizontal line.

The components can subsequently be picked up from the various supply positions by means of different component pick-up and placement devices and be placed at a desired position on a substrate, for example.

Yet another embodiment of the component supplying device according to the invention is characterized in that, in operation, the first component pick-up device is located near the supply position if the second component pick-up device is located near the pick-up position, and vice versa.

Because the component pick-up devices are alternately located near the supply position and the pick-up position, the component pick-up devices will not interfere with one another.

Yet another embodiment of the component supplying device according to the invention is characterized in that the wafer holder is movable relative to the pick-up position.

This makes it possible to keep the pick-up position at a fixed location relative to the supply positions, so that a component can each time be supplied at the pick-up position by moving the wafer holder and the wafer supported by said holder.

The invention also relates to a method that is characterized in that a component is picked up from the pick-up position alternately by means of at least a first and a second component pick-up device, the component pick-up devices being movable along a first and a second guide arranged at an angle relative to one another to a first and second supply position, respectively.

This makes it possible to remove components from a wafer relatively quickly and supply them alternately to different supply positions.

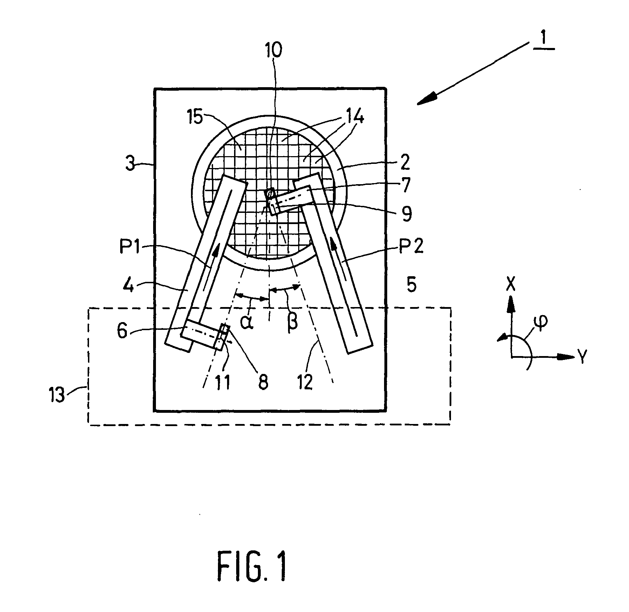

The invention will be further elucidated with reference to figure 1, which shows a component supplying device according to the invention.

Figure 1 shows a component supplying device 1 according to the invention that is provided with a frame 3 supporting a wafer holder 2. The wafer holder 2 extends in a horizontal plane, being movable by means that are known per se relative to the frame 3 in the directions indicated by the arrows X and Y and in the opposite directions and being rotatable in the direction indicated by arrow ϕ and in the opposite direction.

The frame 3 supports two guides 4, 5 which are each provided with a component pick-up device 6, 7 that is movable along the guides 4, 5. The guide 4 extends at an angle α relative to the Y axis, while the guide 5 extends at an angle β relative to the Y axis. In the case of the component supplying device 1 according to the invention as shown herein, α = -β. The component pick-up devices 6, 7 are each provided with a nozzle 8, 9. The component pick-up device 6 can be moved in the direction indicated by the arrow P1 and in the opposite direction, the nozzle 8 being movable from a pick-up position 10 located near the centre of the wafer holder 2 to a supply position 11 lying at some distance from the pick-up position 10. The nozzle 9 of the component pick-up device 7 can be moved in the direction indicated by arrow P2 and in the opposite direction between the pick-up position 10 and a supply position 12 lying at some distance from it. The supply positions 11, 12 lying at some distance from one another preferably lie along a line that extends parallel to the X axis. The supply positions 11, 12 are located near part 13 of a component pick-up and placement device that is known per se.

The component supplying device 1 according to the invention works is as follows. A wafer 15 supported by the wafer holder 2 and provided with components 14 is moved by the means known per se in the X, Y and ϕ directions and the opposite directions until a component to be picked up 14 is present at the pick-up position 10. One of the component pick-up devices 6, 7 is then moved to the pick-up position 10, so that the component 14 can be picked up by means of the nozzle 8, 9. The picked-up component is subsequently moved along the guide 4, 5 to the supply position 11, 12. While a component 14 is being picked up from the pick-up position 10 by one of the component pick-up devices 6, 7, a component 14 is supplied at the supply position 11, 12 by the other component pick-up device 6, 7. The component 14 is picked up from the supply position 11, 12 by the component pick-up and placement device and is subsequently placed at a desired position on a substrate, for example.

A component supplying device 1 on a side of the wafer holder 2 facing away from the component pick-up devices 6, 7 is usually provided with a pin, that presses the component to be picked up 14 upwards. Because the pick-up position 10 in the component supplying device 1 according to the invention is the same for both component pick-up devices 6, 7, only one such a pin need be provided.

In a component pick-up and placement device the distance between two supply positions 11, 12 is preferably as small as possible, so that as many supply positions as possible can be provided in the component pick-up and placement device. The wafer 15 may extend vertically, in a manner comparable to that shown in US-A-5,671,530, to make it possible to supply a component from a relatively large wafer at supply positions.

In the component supplying device 1 according to the invention, the wafer 15 may, however, also extend horizontally, with several supply positions 11, 12 being provided in the space taken up by the wafer 15. Because the supply positions 11, 12 are alternately provided with components, the frequency at which components 14 are available is relatively high.

The angles α and β may also differ from one another.

## Claims

1. A component supplying device that is provided with at least a wafer holder and at least one component pick-up device that is movable along a guide, which device is movable between at least one pick-up position located near the wafer holder and a supply position spaced therefrom by some distance, **characterized in that** the component supplying device is provided with at least a first and a second component pick-up device which are movable along a first and a second guide, respectively, which guides are arranged at an angle relative to one another, the first component pick-up device being movable between the pick-up position and a first supply position, while the second component pick-up device is movable between the pick-up position and a second supply position.

2. A component supplying device according to claim 1, **characterized in that** the wafer holder extends substantially horizontally.

3. A component supplying device according to claim 1, **characterized in that**, in operation, the first component pick-up device is located near the supply position if the second component pick-up device is located near the pick-up position, and vice versa.

4. A component supplying device according to any one of the preceding claims, **characterized in that** the wafer holder is movable relative to the pick-up position.

5. A method for picking up a wafer supported by a wafer holder and provided with components, according to which a component lying at a pick-up position is picked up by means of a component pick-up device, after which the component pick-up device supporting the component is moved along a guide to a supply position, **characterized in that** a component is picked up from the pick-up position alternately by means of at least a first and a second component pick-up device, the component pick-up devices being movable along a first and a second guide arranged at an angle relative to one another to a first and a second supply position, respectively.
